# EUROPÄISCHE PATENTSCHRIFT

(11) **EP 0 660 972 B1**
(45) Veröffentlichungstag und Bekanntmachung des Hinweises auf die Patenterteilung: **25.09.1996**
(21) Anmeldenummer: 93915685.7
(22) Anmeldetag: 05.08.1993
(51) Int. Cl.: H02H 7/085, H02H 7/093, H02K 11/00

(54) **VERFAHREN UND VORRICHTUNG ZUR ELEKTRONISCHEN ÜBERLASTÜBERWACHUNG AN ELEKTROMOTORISCHEN ANTRIEBEN**
PROCESS AND DEVICE FOR ELECTRONICALLY MONITORING THE OVERLOAD ON ELECTRIC MOTOR DRIVES
PROCEDE ET DISPOSITIF DE SURVEILLANCE ELECTRONIQUE DE SURCHARGE SUR DES COMMANDES A MOTEUR ELECTRIQUE

(30) Priorität: 16.09.1992 DE 4230873
(43) Veröffentlichungstag der Anmeldung: 05.07.1995
(73) Patentinhaber: LEICA MIKROSKOPIE UND SYSTEME GmbH, D-35530 Wetzlar (DE)
(72) Erfinder: FELGENHAUER, Klaus, D-35753 Greifenstein (DE)
(74) Vertreter: Stamer, Harald, Dipl.-Phys.
(86) Internationale Anmeldenummer: DE9300685
(87) Internationale Veröffentlichungsnummer: WO9407289

(56) Entgegenhaltungen:
- EP-A- 0 456 874
- FR-A- 2 123 145
- GB-A- 1 363 738
- SOVIET INVENTIONS ILLUSTRATED, P,Q Sektionen, Woche 8423, 18. Juli 1984, DERWENT PUBLICATIONS LTD., London, R 57, & SU-A-1043-398

## Beschreibung

Die Erfindung betrifft ein Verfahren und eine Schaltungsanordnung zur Durchführung des Verfahrens mit den Merkmalen des Oberbegriffs der Ansprüche 1 und 3.

Elektromotorische Antriebe werden sehr vielseitig eingesetzt, z.B. zum Antrieb von Elektrowerkzeugen, Haushaltsgeräten, Büromaschinen, Pumpen, Förderanlagen, Positioniereinrichtungen, elektrischen Bahnen usw. Man unterscheidet Gleichstrom-, Wechselstromund Drehstrommotoren sowie Schrittmotoren, die entweder im Dauerstrombetrieb oder im Pulsstrombetrieb eingesetzt werden.

Allen Anwendungen ist gemeinsam, daß der elektromotorische Antrieb einen Gegenstand bewegen muss, der je nach Anwendungsfall ein großes Gewicht haben kann (z.B. das Fördergut und das Förderband bei elektrisch betriebenen Förderanlagen oder das elektrisch verfahrbare Portal einer Portalmeßmaschine). Um den Gegenstand zu bewegen, muss der elektromotorische Antrieb elektrische Leistung aufnehmen, die sogenannte Wirkleistung. Je schwerer der zu bewegende Gegenstand ist, umso größer ist die Belastung des Motors und damit die Wirkleistung des Motors. Eine wesentliche Änderung der Wirkleistung tritt im Zeitpunkt der Lastzuschaltung ein, d.h. wenn der elektromotorische Antrieb mit dem zu bewegenden Gegenstand in mechanische Verbindung gebracht wird ( z.B. durch eine Kupplung zwischen beiden). Ebenso handelt es sich um eine Lastzuschaltung, wenn z. B. ein elektrisch angetriebener Fräser das zu bearbeitende Werkstück berührt.

Nach dem Einschalten des elektromotorischen Antriebs steigert sich seine Drehzahl kontinuierlich bis zum Erreichen der Solldrehzahl, die für den jeweiligen Anwendungsfall festgelegt ist. Die Solldrehzahl bei nicht zugeschalteter Last wird als Leerlaufdrehzahl bezeichnet. Bei Lastzuschaltung sinkt die Solldrehzahl vom Wert der Leerlaufdrehzahl lastproportional ab. Die Zeit zwischen Einschalten des elektromotorischen Antriebs und Erreichen der Solldrehzahl wird als Anlaufphase, die danach als Dauerbetrieb bezeichnet.

Im Dauerbetrieb wird die Belastbarkeit eines elektromotorischen Antriebs durch seine Erwärmung begrenzt. Die tatsächliche Wirkleistung im Dauerbetrieb wird als Solleistung, die maximal zulässige Solleistung wird als Nennleistung bezeichnet. Elektromotorische Antriebe dürfen kurzzeitig über ihre Nennleistung hinaus belastet werden.

Die Wirkleistung läuft während der Anlaufphase, also nach dem Einschalten des elektromotorischen Antriebs, von Null ausgehend sehr schnell auf einen Spitzenwert deutlich oberhalb der Nennleistung und sinkt erst bei Erreichen der Solldrehzahl auf den Wert der Solleistung. Der Spitzenwert der Wirkleistung entsteht, weil der elektromotorische Antrieb zunächst die eigene mechanische Trägheit überwinden muss und die Wirkleistungsaufnahme in der Anlaufphase nur durch Wicklungswiderstand und -induktivität des elektromotorischen Antriebs begrenzt wird. Für einen unter Last stehenden elektromotorischen Antrieb liegt dieser Spitzenwert über dem des unbelasteten elektromotorischen Antriebs.

Ein Verfahren der eingangs genannten Art ist bekannt zur Vermeidung von Überhitzung eines elektromotorischen Antriebs selbst oder z.B. auch zur Erkennung von Werkzeugverschleiß und Werkzeugbruch an elektromotorisch betriebenen Werkzeugmaschinen. Es eignet sich zur Überlastüberwachung von elektromotorischen Antrieben (Gleichstrom, Wechselstrom oder Drehstrom) im Dauerstrombetrieb, deren Last erst nach Erreichen der Solldrehzahl zugeschaltet wird, wie z.B. Werkzeugmaschinen. Hierbei wird ausgenutzt, daß der zeitliche Verlauf der Wirkleistungskurve ab Erreichen der Solldrehzahl konstant ist und nach Zuschalten der Last auf ein lastproportionales Niveau ansteigt. Bei Auftreten einer Überlast steigt die aktuelle Wirkleistung sprunghaft an. Daher zeigt ein Vergleich der aktuellen Wirkleistung mit einer den Überlastzustand repräsentierenden Leistungswarnschwelle, die für zeitlich veränderliche Lasten selbst zeitabhängig ist, das Erreichen eines kritischen Zustandes an. Bei Überschreiten der Leistungswarnschwelle wird dann ein Schalt- und /oder Warnsignal ausgelöst.

Für die Überwachung wird die Stromaufnahme gemessen und daraus die aktuelle Wirkleistung bestimmt. Die Strommessung geschieht bei mit Gleichstrom betriebenen elektromotorischen Antrieben durch einen Hall-Sensor, bei mit Wechselstrom betriebenen durch einen Stromwandler. Die Strommessung kann dauernd durchgeführt werden.

Die eigentliche Überwachung mit Schwellwertvergleich wird jedoch bei dem bekannten Verfahren erst nach Durchlaufen der Anlaufphase des elektromotorischen Antriebs eingeschaltet. Dies geschieht zu einem vorgewählten Zeitpunkt nach Einschalten des elektromotorischen Antriebs, da der übliche zeitliche Verlauf der Wirkleistungskurve bekannt ist. Der Einschaltzeitpunkt kann aber auch aus dem Erreichen eines konstanten Wertes der Wirkleistung bestimmt werden.

Das bekannte Verfahren deckt somit nicht alle Betriebszustände eines elektromotorischen Antriebs ab. Dies beruht darauf, daß bei allen elektromotorischen Antrieben in der Anlaufphase die Leistungsaufnahme schnell auf einen Spitzenwert weit oberhalb der Leistungswarnschwelle für einen Überlastzustand steigt und danach erst bei Erreichen der Solldrehzahl auf einen konstanten Wert weit unterhalb des Spitzenwertes fällt. In der Praxis wird der beschriebene Spitzenwert häufig wegen Übersteuerung der Verstärkerstufen der Stromversorgungseinrichtung des elektromotorischen Antriebs nicht erreicht, sondern es entsteht vor dem Erreichen des Spitzenwertes im zeitlichen Verlauf der Wirkleistung weit oberhalb der Leistungswarnschwelle ein Plateau. Dessen Höhe ist durch die Stromverstärkerbegrenzung bestimmt. Im Bereich der Verstärkerbegrenzung sind zusätzliche Spitzenwerte, die durch Überlasten hervorgerufen werden, daher auch nicht messbar. Daher eignet sich das bekannte Verfahren nicht für die Überlastüberwachung während der Anlaufphase eines elektromotorischen Antriebs.

Das bekannte Verfahren kann daher auch nicht für die Überlastüberwachung pulsbetriebener elektromotorischer Antriebe oder Schrittmotoren verwendet werden, weil diese, z. B. bei kurzen Verfahrstrecken oder langsamen Verfahrgeschwindigkeiten, unterhalb ihrer Solldrehzahl betrieben werden, im Sinne der vorstehenden Beschreibung also nicht aus der Anlaufphase herauskommen.

Die Überlastüberwachung in allen Betriebszuständen ist aber insbesondere für elektromotorische Antriebe mit dauerhaft zugeschalteter Last (z.B. Positioniervorrichtungen) wünschenswert, weil diese bereits vor Erreichen der Nenndrehzahl einen Überlastzustand erreichen können (z.B. durch mechanisches Festfahren).

Der Erfindung liegt daher die Aufgabe zugrunde, ein Verfahren und eine Schaltungsanordnung anzugeben, welche auch eine Überwachung des Betriebszustands eines elektromotorischen Antriebs unterhalb der Solldrehzahl gestatten und damit eine Überlastüberwachung nicht nur bei elektromotorischen Antrieben im Dauerstrombetrieb sondern auch im gepulsten Betrieb bzw. auch bei sogenannten Schrittmotoren ermöglichen.

Diese Aufgabe wird bei einem Verfahren der eingangs genannten Art erfindungsgemäß durch die kennzeichnenden Merkmale des Anspruchs 1 gelöst. Eine Schaltungsanordnung zur Ausübung dieses Verfahrens ist im Anspruch 3 gegeben. Vorteilhafte Weiterbildungen des Verfahrens sowie vorteilhafte Ausbildungen der Vorrichtung ergeben sich aus den jeweiligen Unteransprüchen.

Durch die Erfindung wird eine elektronische Überlastüberwachung an elektromotorischen Antrieben geschaffen, die sowohl bei elektromotorischen Antrieben mit zuschaltbarer Last als auch bei solchen mit dauerhaft zugeschalteter Last verwendbar ist. Sie bietet den Vorteil, auch in der Anlaufphase des elektromotorischen Antriebs, also vor Erreichen der Nenndrehzahl, Überlastzustände sicher erkennen zu können. Damit kann eine Überlastüberwachung sowohl an Elektromotoren im Dauerstrombetrieb als auch an Schrittmotoren bzw. an gepulst betriebenen Elektromotoren erfolgen.

Die Erfindung beruht darauf, den Betriebszustand eines elektromotorischen Antriebs in der Anlaufphase durch Beobachten einer der erwarteten Bewegung des elektromotorischen Antriebs proportionalen Meßgröße zu überwachen. Eine solche Meßgröße ist die Geschwindigkeit des elektromotorischen Antriebs. Es kann sowohl die Drehgeschwindigkeit eines Elektromotors als auch bei Linear-Verstell-Antrieben die Vortriebsgeschwindigkeit zur Überwachung herangezogen werden.

Zusätzlich zur Wirkleistungsmessung mit Leistungsschwellwert-Vergleich nach Erreichen der Nenndrehzahl wird die aktuelle Geschwindigkeit gemessen und mit einem von der Einschaltzeit des elektromotorischen Antriebs abhängigen Geschwindigkeitsschwellwert verglichen, der einem Überlastzustand entspricht. Sobald eine Überlastung auftritt, verringert sich die aktuelle Geschwindigkeit. Bei Unterschreiten des Geschwindigkeitsschwellwertes wird ein unabhängiges Schalt- und/oder Warnsignal mit der Kennung "Überlast" ausgelöst.

Das erfindungsgemäße Verfahren und die erfindungsgemäße Schaltungsanordnung werden nachfolgend anhand eines Ausführungsbeispiels beschrieben.

Es zeigen:

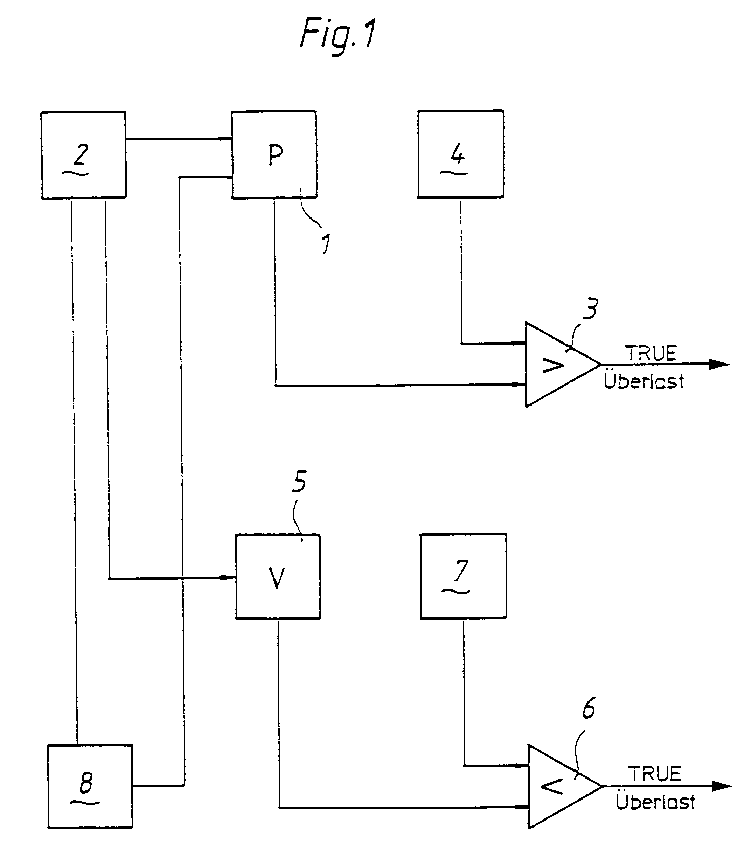

- Fig.1:: ein Ausführungsbeispiel einer erfindungsgemäßen Schaltungsanordnung mit einem zu überwachenden elektromotorischen Antrieb;
- Fig.2:: einen typischen zeitlichen Verlauf der Wirkleistung und der Drehgeschwindigkeit eines elektromotorischen Antriebs mit nach Erreichen der Solldrehzahl zuschaltbarer konstanter Last;
- Fig.3:: einen typischen zeitlichen Verlauf der Wirkleistung und der Drehgeschwindigkeit eines elektromotorischen Antriebs mit dauerhaft zugeschalteter konstanter Last.

An einen zu überwachenden und nur schematisch dargestellten elektromotorischen Antrieb 2 mit Drehwinkelgeber sind ein Wirkleistungsmesser 1 und ein Geschwindigkeitsmesser 5 angeschlossen. Der elektromotorische Antrieb 2 wird von einer nicht dargestellten Stromversorgungseinrichtung versorgt. Auf Veranlassung einer Steuerelektronik 8, die mit dem elektromotorischen Antrieb 2 und dem Wirkleistungsmesser 1 verbunden ist, wird bei bzw. nach Erreichen der Solldrehzahl des elektromotorischen Antriebs die eigentliche Wirkleistungsüberwachung aktiviert. Dies geschieht nach einer entsprechend vorgewählten Zeit nach Einschalten des elektromotorischen Antriebs 2, da der übliche zeitliche Verlauf der Wirkleistungskurve bekannt ist, oder in Abhängigkeit von der tatsächlich gemessenen Drehzahl. Ab diesem Zeitpunkt wird das Ausgangssignal des Wirkleistungsmessers 1 auf den ersten Eingang eines ersten Komparators 3 geführt. Dem zweiten Eingang des ersten Komparators 3 wird ein einen Überlastzustand repräsentierender Leistungsschwellwert zugeführt, der vom Leistungsschwellwert-Speicher 4 abgefragt wird.

Da die Wirkleistung eine lastproportionale Größe ist, wird der Leistungschwellwert um einem bestimmten Betrag oberhalb der durch die regulär zugeschaltete Last bedingten Wirkleistung vorgewählt. Bei zeitlich konstanter Last ist der Leistungsschwellwert daher ebenfalls zeitlich konstant. Ändert sich die Last zeitabhängig, z.B. während eines Arbeitsganges einer Werkzeugmaschine, können im Leistungsschwellwert-Speicher 4 zeitabhängige Leistungsschwellwerte abgespeichert werden. Dem ersten Komparator 3 wird dann der dem jeweiligen Zeitpunkt der Wirkleistungsmessung zugehörige Leistungsschwellwert zugeführt.

Überschreitet die aktuell gemessene Wirkleistung den Leistungsschwellwert, liefert der erste Komparator 3 an seinem Ausgang ein Signal, welches ein Schalt- und/oder Warnsignal mit der Kennung "Überlast" auslöst. Damit kann z.B. die Abschaltung des Antriebs angesteuert werden.

Der Geschwindigkeitsmesser 5 wird nicht von der Steuerelektronik 8 angesteuert. Er mißt ständig, also auch während der Anlaufphase vor Erreichen der Solldrehzahl, die Geschwindigkeit des elektromotorischen Antriebs 2. Dazu kann entweder die Vortriebsgeschwindigkeit durch Messen der Linearbewegung pro Zeitintervall oder die Drehgeschwindigkeit durch Messen des Drehwinkels pro Zeitintervall gemessen werden. In diesem Ausführungsbeispiel soll am elektromotorischen Antrieb 2 ein nicht dargestellter Drehwinkelgeber vorgesehen sein.

Das Ausgangssignal des Geschwindigkeitsmessers 5 wird auf den ersten Eingang eines zweiten Komparators 6 geführt. Auf dessen zweiten Eingang wird ein von einem Geschwindigkeitsschwellwert-Speicher 7 abgefragter, zeitabhängiger, einen Überlastzustand repräsentierender Geschwindigkeitsschwellwert geführt. Dieser Geschwindigkeitsschwellwert gibt die tolerierte Abweichung von der unter normalen Betriebsbedingungen erwarteten Bewegung des elektromotorischen Antriebs an. Dabei hängt die erwartete Bewegung vom Einschaltzeitpunkt des elektromotorischen Antriebs ab, ab welchem dieser mit Dauerstrom oder mit gepulstem Strom betrieben wird. Unterschreitet die aktuell gemessene Geschwindigkeit den Geschwindigkeitsschwellwert, zeigt dies einen Überlastzustand an. Der zweite Komparator 6 liefert dann an seinem Ausgang ein Signal, welches ein von der Wirkleistung unabhängiges Schalt- und/oder Warnsignal mit der Kennung "Überlast" auslöst.

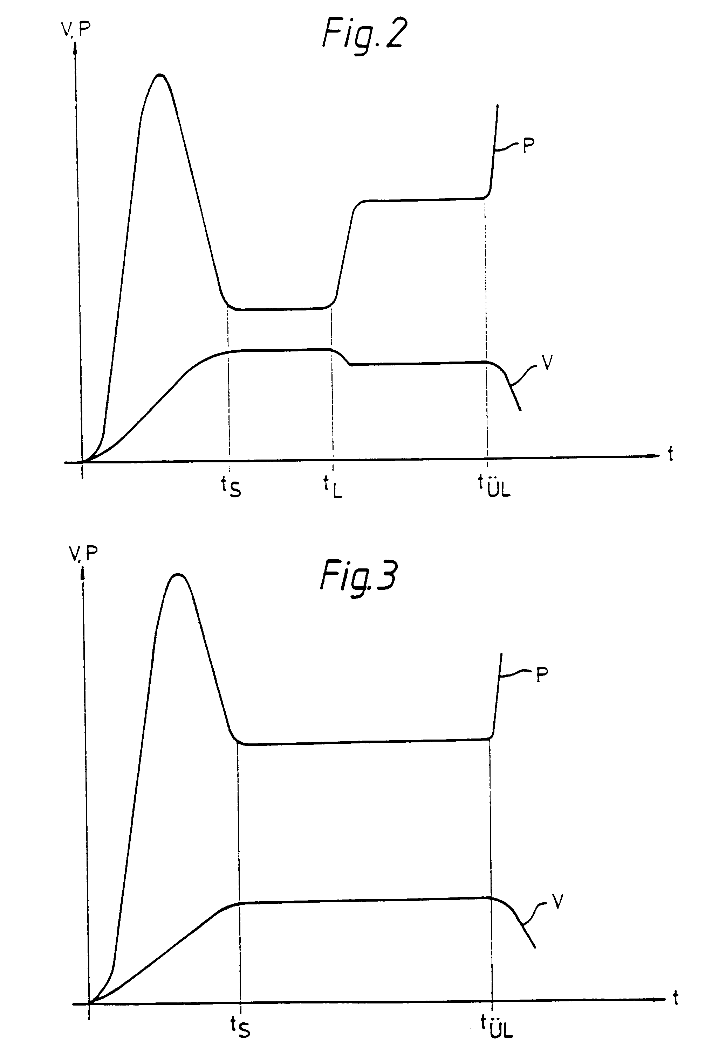

Fig.2 zeigt den typischen zeitlichen Verlauf der Wirkleistung und der Geschwindigkeit eines elektromotorischen Antriebs im Dauerstrombetrieb, dessen Last nach Erreichen der Solldrehzahl zugeschaltet wird. Fig.3 zeigt dieselben Meßgrößen für einen elektromotorischen Antrieb im Dauerstrombetrieb mit Dauerlast. Zum Zeitpunkt t_{S} ist die Solldrehzahl erreicht. t_{L} bezeichnet den Zeitpunkt der Lastzuschaltung in Fig.2, der in Fig.3 wegen der dauerhaft zugeschalteten Last nicht dargestellt ist. Mit t_{ÜL} ist ein Zeitpunkt angegeben, an dem hier in den Beispielen eine Überlast auftritt.

Man erkennt aus Fig.2 und 3 den stetigen Anstieg der Geschwindigkeit bis zum Erreichen der Solldrehzahl. Danach ist die Geschwindigkeit lastabhängig, d.h. sie sinkt mit steigender Last. Eine konstante Last bewirkt, wie dargestellt, eine konstante Geschwindigkeit.

Die Wirkleistung steigt von Null an und erreicht einen lastabhängigen Spitzenwert. Dieser ist daher in Fig.3, also bei zugeschalteter Dauerlast, entsprechend größer als Fig. 2. Nach Erreichen des Spitzenwertes sinkt die Wirkleistung bei Erreichen der Solldrehzahl auf ein Leerlaufniveau. Sobald die Last zugeschaltet wird, steigt sie dann auf ein lastproportionales Niveau. Oberhalb dieses lastproportionalen Wirkleistungswertes wird der Leistungsschwellwert gewählt. Entsprechend wird für die Geschwindigkeit ein Schwellwert unterhalb der dargestellten Geschwindigkeit festgelegt.

Tritt nach Erreichen der Solldrehzahl und nach Lastzuschaltung zum Zeitpunkt T_{ÜL} eine Überlast auf, steigt die Wirkleistung sprunghaft an. Demgegenüber sinkt die Geschwindigkeit im Überlastfall vergleichsweise langsamer als die Wirkleistung steigt. Man erkennt, daß auch nach Erreichen der Nenndrehzahl und nach Zuschaltung der Last eine Überlastüberwachung mit Hilfe einer Geschwindigkeitskontrolle mit Schwellwertvergleich möglich ist. Die Überlastüberwachung mit Hilfe einer Wirkleistungskontrolle mit Schwellwertvergleich ist sozusagen die "flinkere" Methode, da hier der Schwellwert in kürzerer Zeit erreicht wird. Demgegenüber ist die Geschwindigkeitskontrolle mit Schwellwertvergleich die "trägere" Methode, weil sie bei Überlast langsamer anspricht. Dies kann man sich je nach Anwendungsfall zunutze machen. So kann es gewünscht sein, daß kleine kurzzeitige Überlasten nicht sofort zur Systemabschaltung führen. In diesem Fall wäre die "trägere" Methode zu bevorzugen, wobei die Überlastwarnungen aufgrund der Wirkleistungskontrolle unterdrückt werden müßten. Für die Mehrzahl der Systeme wird man die kombinierte Überwachung wählen, d.h. in der Anlaufphase wird die Geschwindigkeit kontrolliert, im Dauerbetrieb ab Erreichen der Solldrehzahl dagegen die Wirkleistung.

Für die Betriebszustände vor Erreichen der Solldrehzahl ist die Wirkleistungskontrolle mit Schwellwertvergleich wegen des beschriebenen Durchlaufens eines Spitzenwertes weit oberhalb des Leistungsschwellwertes ungeeignet. Dafür ist in diesem Bereich die Überlastüberwachung mit Hilfe der Geschwindigkeitskontrolle mit Schwellwertvergleich sehr feinfühlig, weil in der Anlaufphase die Geschwindigkeit stetig steigt.

Nur durch die vorgeschlagene gegenseitige Ergänzung aus Kontrolle von Wirkleistung und Geschwindigkeit des elektromotorischen Antriebs ist es möglich, auch in solchen Fällen eine Überlastüberwachung zu realisieren, die sich durch kleine Verfahrwege eines dauerbelasteten elektromotorischen Antriebs unterhalb der Solldrehzahl, z.B. auch im Pulsbetrieb auszeichnen. Damit eignet sich die Erfindung insbesondere zur Anwendung bei Positionierantrieben mit sehr kleinen Verfahrwegen, wie sie z.B. bei Scannern für verschiedene Zwecke erforderlich ist (z.B. Probenabtastungen bei Oberflächenuntersuchungen). Ein anderes Anwendungsgebiet findet sich bei motorisierten Funktionen an Mikroskopen, wie z.B. die Höhenverstellung des Objekttisches zu Fokussierzwecken. Diese verlangt sehr kleine Verfahrwege, die nur durch den gepulsten Betrieb des elektromotorischen Antriebs erreicht werden können. Durch die Überlastüberwachung wird dann eine Beschädigung des beobachteten Objekts und des Objektivs durch gegenseitige Kollision vermieden.

Fig. 3 beschreibt die genannten Kurvenverläufe für einen elektromotorischen Antrieb im Dauerstrombetrieb. Für einen elektromotorischen Antrieb im Pulsstrombetrieb erfährt dieser durch die einzelnen Strompulse jeweils kleine Geschwindigkeitszuwächse, die insgesamt zu einem kontinuierlichen Anstieg der Geschwindigkeit und nach einer bestimmten Anzahl von Pulsen zu einer lastproportionalen, konstanten, mittleren Geschwindigkeit führen (vergl. z.B. DE 40 28 241 A1). Damit bewegt sich der zeitliche Verlauf der Geschwindigkeit mit kleinen Abweichungen nach oben und nach unten quasi-oszillierend um den in Fig. 3 dargestellten Verlauf der Geschwindigkeit. Es ergibt sich also auch hier ein von der Einschaltzeit des elektromotorischen Antriebs abhängiger, typischer Kurvenverlauf, von dem Geschwindigkeitsschwellwerte abgeleitet werden können. Mit diesen kann eine Überlastüberwachung in allen Betriebszuständen auch des gepulst betriebenen elektromotorischen Antriebs durchgeführt werden.

Demgegenüber ist im gepulsten Betrieb eine Überlastüberwachung mithilfe einer Wirkleistungskontrolle grundsätzlich unbrauchbar, da der elektromotorische Antrieb mit jedem Strompuls erneut erregt wird, was jedesmal eine neue Anlaufphase bedeutet. Überdies macht man sich im Pulsbetrieb zunutze, daß der kurzzeitige Puls den elektromotorischen Antrieb über die Nennleistung hinaus belasten darf, sofern nur die Wirkleistung im zeitlichen Mittel unterhalb der Nennleistung bleibt. Dies würde bei einer Wirkleistungsüberwachung sofort zu einer Überlastmeldung führen, während ein Heraufsetzen des Leistungsschwellwertes einen eventuell auftretenden Überlastzustand verschleiern würde. Bei pulsstrombetriebenen elektromotorischen Antrieben sowie Schrittmotoren kann daher eine Überlastüberwachung nur durch eine Geschwindigkeitskontrolle erzielt werden.

## Patentansprüche

1. Verfahren zur elektronischen Überlastüberwachung an einem elektromotorischen Antrieb durch
- Messen der aktuell aufgenommenen Wirkleistung des elektromotorischen Antriebs,
- Vergleichen der aktuellen Wirkleistungsaufnahme mit einem einen Überlastzustand repräsentierenden Leistungsschwellwert und
- Auslösen eines Schalt- und/oder Warnsignals bei Überschreiten des Schwellwertes,
dadurch gekennzeichnet, daß
a) zusätzlich ständig die aktuelle Geschwindigkeit des elektromotorischen Antriebs gemessen wird,
b) die aktuelle Geschwindigkeit des elektromotorischen Antriebs mit einem von der Einschaltzeit des elektromotorischen Antriebs abhängigen, einen Überlastzustand repräsentierenden Geschwindigkeitsschwellwert verglichen wird und
c) bei Unterschreiten des Geschwindigkeitsschwellwertes ein zusätzliches, vom ersten unabhängiges Schalt- und/oder Warnsignal mit der Kennung "Überlast" erzeugt wird.

2. Verfahren nach Anspruch 1, **dadurch gekennzeichnet**,
**daß** die geschwindigkeitsabhängige Überlastüberwachung in der Zeit bis zum Erreichen der Solldrehzahl des elektromotorischen Antriebs durchgeführt und danach die wirkleistungsabhängige Überlastüberwachung aktiviert wird.

3. Schaltungsanordnung zur elektronischen Überlastüberwachung an einem elektromotorischen Antrieb mit
- einem Wirkleistungsmesser (1) zum Messen der nach der Anlaufphase vom Antrieb aktuell aufgenommenen Wirkleistung und
- einem Komparator (3), auf dessen ersten Eingang das Ausgangssignal des Wirkleistungsmessers (1) geführt wird und auf dessen zweiten Eingang ein von einem Leistungsschwellwert-Speicher (4) abgefragter, einen Überlastzustand repräsentierenden Schwellwert geführt wird und an dessen Ausgang bei Überschreiten des Leistungsschwellwertes durch die gemessene Wirkleistung ein Signal abgegeben wird, welches ein Schalt- und/oder Warnsignal mit der Kennung "Überlast" auslöst,
gekennzeichnet durch,
a) einen Geschwindigkeitsmesser (5) zur Messung der aktuellen Geschwindigkeit des elektromotorischen Antriebs (2),
b) einen Geschwindigkeitsschwellwert-Speicher (7), in dem zeitabhängige, einen Überlastzustand repräsentierende Geschwindigkeitsschwellwerte gespeichert sind,
c) einen weiteren Komparator (6), auf dessen ersten Eingang das Ausgangssignal des Geschwindigkeitsmessers (5) und auf dessen zweiten Eingang ein von dem Geschwindigkeitsschwellwert-Speicher (7) abgefragter, einschaltzeitabhängiger Geschwindigkeitsschwellwert geführt wird und an dessen Ausgang bei Unterschreiten des Geschwindigkeitsschwellwertes durch die aktuelle Geschwindigkeit ein Signal abgegeben wird, welches ein vom ersten unabhängiges Schalt- oder Warnsignal mit der Kennung "Überlast" auslöst.

4. Schaltungsanordnung nach Anspruch 3, **dadurch gekennzeichnet**,
**daß** als Antrieb ein Schrittmotor bzw. pulsstrombetriebener Elektromotor vorgesehen sind.

5. Schaltungsanordnung nach Anspruch 3, **dadurch gekennzeichnet**,
**daß** an dem elektromotorischen Antrieb (2) ein Drehwinkelgeber zur Bestimmung der aktuellen Geschwindigkeit des elektromotorischen Antriebs (2) angeordnet ist.

## Claims

1. Method for the electronic overload monitoring at an electrical motor drive by
- measurement of the actually consumed real power of the electrical motor drive,
- comparison of the actual real power consumption with a power threshold value representing an overload state and
- triggering a switching and/or warning signal on the threshold value being exceeded,
characterised thereby, that
a) the actual speed of the electrical motor drive is constantly measured in addition,
b) the actual speed of the electrical motor drive is compared with a speed threshold value, which is dependent on the time, for which the electrical motor drive is switched on, and which represents an overload state and
c) an additional switching and/or warning signal, which is independent of the first switching and/or warning signal and has the identification "overload", is generated on the speed threshold value being fallen below.

2. Method according to claim 1, characterised thereby, that the speeddependent overload monitoring is performed in the time before the target rotational speed of the electrical motor drive is reached and the overload monitoring dependent on real power is activated thereafter.

3. Circuit arrangement for the electronic overload monitoring at an electrical motor drive with
- a real power motor (1) for measuring the real power actually consumed by the drive after the starting-up phase and
- a comparator (3), to the first input of which the output signal of the real power motor (1) is led and to the second input of which a threshold value is led, which is interrogated from a power threshold value storage device (4) and represents an overload state, and at the output of which a signal is delivered, which triggers a switching and/or warning signal with the identification "overload", on the power threshold value being exceeded by the measured real power.
characterised by
a) a speed meter (5) for the measurement of the actual speed of the electrical motor drive (2),
b) a speed threshold value storage device (7), in which time-dependent speed threshold values, which represent an overload state, are stored and
c) a further comparator (6), to the first input of which the output signal of the speed meter (5) is led and to the second input of which a speed threshold value is led, which is interrogated from the speed threshold value storage device (7) and dependent on the switch-on time, and at the ouput of which a signal is delivered, which triggers a switching and/or warning signal independent of the first signal and with the identification "overload", on the speed threshold value being fallen below by the actual speed.

4. Circuit arrangement according to claim 3, characterised thereby, that a stepping motor or an electrical motor, which is operated by pulsed current, is provided as drive.

5. Circuit arrangement according to claim 3, characterised thereby, that a rotary angle transmitter for ascertaining the actual speed of the electrical motor drive (2) is arranged at the electrical motor drive (2).

## Revendications

1. Procédé pour la surveillance électronique de surcharge dans une commande à moteur électrique, par
- mesure de la puissance réelle absorbée actuellement de la commande par moteur électrique,
- comparaison de l'absorption de puissance réelle actuelle à une valeur de seuil de puissance représentatif d'un état de surcharge, et
- déclenchement d'un signal de commutation et/ou d'alarme lors du dépassement de la valeur de seuil,
caractérisé en ce que
a) supplémentairement, de façon permanente, la vitesse actuelle de la commande par moteur électrique est mesurée,
b) la vitesse actuelle de la commande par moteur électrique est comparée à une valeur de seuil de vitesse dépendant du temps de mise en service de la commande par moteur électrique et représentatif d'un état de surcharge et
c) lors du dépassement en dessous de la valeur de seuil de vitesse est engendré un signal de commutation et/ou d'alarme, supplémentaire et dépendant du premier, avec la marque "surcharge".

2. Procédé selon la revendication 1, caractérisé en ce que la surveillance de surcharge, dépendant de la vitesse est effectuée dans la période de temps jusqu'à l'atteinte du nombre de tours de consigne de la commande par moteur électrique et qu'ensuite la surveillance de surcharge dépendant de la puissance réelle est activée.

3. Dispositif pour la surveillance électronique de surcharge dans une commande par moteur électrique, avec
un mètre de la puissance réelle (1) pour la mesure de la puissance réelle absorbée actuellement par la commande, après la phase de démarrage, et
un comparateur (3) à la première entrée duquel est appliqué le signal de sortie du mètre de puissance réelle (1) et à la seconde entrée duquel est appliquée une valeur de seuil prélevée par interrogation d'une mémoire de valeurs de seuil de puissance (4) et représentatif d'un état de surcharge et à la sortie duquel, lors du dépassement de la valeur de seuil de puissance par la puissance réelle mesurée, est produit un signal qui déclenche un signal de commutation et/ou d'alarme avec la marque "surcharge",
caractérisé par
a) un tachomètre (5) pour la mesure de la vitesse actuelle de la commande par moteur électrique (2),
b) une mémoire de valeur de seuil de vitesse (7), dans lequel sont stockées des valeurs de seuil de vitesse dépendant du temps et représentant un état de surcharge,
c) un autre comparateur (6) à la première entrée duquel est appliqué un signal de sortie du tachomètre (5) et à la seconde entrée duquel est appliquée une valeur de seuil de vitesse prélevée par interrogation de la mémoire de valeur de seuil de vitesse (7) et dépendant du temps de mise en service, et à la sortie duquel, lors du dépassement en dessous de la valeur de seuil de vitesse par la vitesse actuelle, est produit un signal qui déclenche un signal de commutation ou d'alarme, dépendant du premier signal et comportant la marque "surcharge".

4. Dispositif selon la revendication 3, caractérisé en ce qu'un moteur pas-à-pas ou un électromoteur à entraînement par impulsion de courant est prévu à titre de commande.

5. Dispositif selon la revendication 3, caractérisé en ce qu'un générateur d'angle de rotation est prévu sur la commande par moteur électrique (2) pour la détermination de la vitesse actuelle de la commande par moteur électrique (2).
